(19) Europäisches Patentamt
European Patent Office
Office européen des brevets

(11) EP 1 029 945 A1

(12) # EUROPÄISCHE PATENTANMELDUNG

(43) Veröffentlichungstag:
**23.08.2000 Patentblatt 2000/34**

(51) Int Cl.[7]: **C23C 30/00**, C23C 14/06, B23B 27/00

(21) Anmeldenummer: **99103093.3**

(22) Anmeldetag: **17.02.1999**

(84) Benannte Vertragsstaaten:
**AT BE CH CY DE DK ES FI FR GB GR IE IT LI LU MC NL PT SE**
Benannte Erstreckungsstaaten:
**AL LT LV MK RO SI**

(71) Anmelder: **BALZERS AKTIENGESELLSCHAFT**
**9496 Balzers (LI)**

(72) Erfinder:
- **Derflinger, Volker**
  **6800 Feldkirch (AT)**
- **Zimmermann, Harald**
  **6880 Feldkirch-Levis (AT)**
- **Wohlrab, Christian**
  **6800 Feldkirch (AT)**

(74) Vertreter: **Troesch Scheidegger Werner AG**
**Patentanwälte,**
**Siewerdtstrasse 95,**
**Postfach**
**8050 Zürich (CH)**

(54) **Verfahren zum Beschichten von Werkzeugen**

(57) Es wird vorgeschlagen, die Schutzbeschichtung von spanenden Werkzeugen an Wirkungskantenbereichen des Werkzeuges dann gezielt bezüglich der Schutzbeschichtungs-Zusammensetzung an übrigen Werkzeug-Flächen zu verändern, wenn an das Werkzeug primär Forderungen bezüglich Härte der Schutzbeschichtung gestellt werden, dann hingegen möglichst gleich wie an den übrigen Werkzeugflächen zu belassen, wenn an das Werkzeug primär Forderungen bezüglich Haftfestigkeit der Schutzbeschichtung gestellt werden.

EP 1 029 945 A1

## Beschreibung

Definition

- In der vorliegenden Beschreibung wird als Hartstoff eine Verbindung, nämlich ein Karbid, Oxid, Oxikarbid, aber insbesondere ein Nitrid, Nitrokarbid, Oxinitrid bzw. Nitrooxikarbid verstanden von mindestens zwei der nachfolgend erwähnten metallischen Elementen, insbesondere von Ti und Al. Als metallische Elemente werden Ti, Zr, Hf, V, Nb, Ta, Cr, Mo, W und Al verstanden.

- Wenn im Rahmen der vorliegenden Anmeldung von einer Änderung der Zusammensetzung des Hartstoffschichtmaterials im Wirkungskantenbereich gesprochen wird, so verstehen wir darunter eine Differenz von mindestens 2 at% einer HartstoffschichtMetallkomponente zwischen Hartstoffschicht im Wirkungskantenbereich und Hartstoffschicht in übrigen Bereichen des Werkzeuges.
  Analog liegt keine Änderung vor, wenn die erwähnte Differenz geringer ist als 2 at%, insbesondere geringer als 1 at%.

- Als Spanungsquerschnitt f $a_p$ wird das Produkt "Vorschub x Schnitttiefe" entsprechend DIN 6580, Abschnitt 11.1.1, "Bewegungen und Geometrie des Zerspanungsvorganges" (DIN 6580, Okt. 1985) verstanden.

Aus der DE-38 25 399 sowie der EP-0 352 545 ist es bekannt, Werkzeuge mittels eines Vakuumverfahrens mit einer Hartstoffschicht zu beschichten, dabei insbesondere mit einer (Ti,Al)N-Hartstoffschicht. Die Beschichtung erfolgt so, dass im Wirkungskantenbereich, d.h. im Bereich der Schneidkanten, das Hartstoffschichtmaterial eine veränderte Zusammensetzung aufweist, verglichen mit derjenigen an übrigen Werkzeugbereichen: Gemäss der DE-38 25 399 sowie der EP-0 352 545 wird an den Wirkungskantenbereichen von Bohrern eine Ausdünnung des Aluminiums realisiert, was an den Werkzeugen durch rötliche oder gelbliche Färbung dieser Bereiche erkennbar ist. Es werden Ausdünnungsverhältnisse von 5 at% bzw. 2 Massen-% des Al angegeben.

Das gefundene Vorgehen, nämlich Verändern der Hartstoffschicht-Zusammensetzung im Wirkungskantenbereich, wird grundsätzlich als Massnahme dargestellt, eine wesentliche Verbesserung der Beschichtungsgüte zu erzielen.

Es ist Aufgabe der vorliegenden Erfindung, generell ausgehend von Werkzeugen, bei denen die vorgesehene Hartstoffschicht im Wirkungskantenbereich eine im wesentlichen und im Rahmen der Messbarkeit unveränderte Materialzusammensetzung aufweist, sowie von Werkzeugen, bei denen, im Gegensatz zu ersterwähnten, im Wirkungskantenbereich die Zusammensetzung der Hartstoffschicht ändert, jeweils bezogen auf die Hartstoffschicht-Zusammensetzung an übrigen Werkzeugbereichen, ein Verfahren zum Schutzbeschichten von spanenden Werkzeugen sowie einen Satz von mindestens zwei Werkzeugen vorzuschlagen, mittels welchen wesentlich verbesserte spezifische Bearbeitungseigenschaften erzielt werden. Insbesondere wird als zu verbessernde Bearbeitungseigenschaft die Werkzeugstandzeit bzw. die Verringerung des Werkzeugverschleisses verstanden.

Gemäss dem Verfahren nach Anspruch 1 wird jedenfalls auf die Werkzeug-Grundkörper eine Hartstoffschicht aufgebracht, wobei aber, Werkzeug-beanspruchungs-spezifisch, die Hartstoffschicht-Zusammensetzung im Wirkungskantenbereich gegenüber der Hartstoffschicht-Zusammensetzung in übrigen Beschichtungsbereichen am Werkzeug-Grundkörper entweder möglichst unverändert belassen wird oder gezielt verändert wird. Ersteres - konstante Zusammensetzung - wird realisiert, wenn die an die Werkzeuge primären Forderungen bezüglich Haftfestigkeit der Hartstoffschicht und nur sekundär bezüglich Härte der Hartstoffschicht zu stellen sind, hingegen zweiteres, wenn an die Werkzeuge primär Forderungen bezüglich Härte der Hartstoffschicht und nur sekundär bezüglich Haftfestigkeit der Hartstoffschicht zu stellen sind.

Erfindungsgemäss wurde mithin erkannt, dass die pauschalisierenden, vorbeschriebenen Wirkungsangaben veränderter bzw. unveränderter Hartstoffschicht-Zusammensetzung in Wirkungskantenbereichen von spanenden Werkzeugen nicht zulässig sind, dass nämlich, in Funktion des Bearbeitungszweckes der Werkzeuge, einmal eine Zusammensetzungs-konstante Hartstoffbeschichtung, einmal eine Zusammensetzungs-variierende Hartstoffbeschichtung im Wirkungskantenbereich in der Praxis, d.h. im Werkzeugeinsatz, erst zu massgeblichen Verbesserungen führt: Werden Werkzeuge für gegebene Einsatzbedingungen mit der falschen der beiden erwähnten Beschichtungstechnologien beschichtet, so wird damit oft eine Verschlechterung seiner Bearbeitungseigenschaften, insbesondere seiner Standzeiten, erreicht.

So konnte gezeigt werden, dass mit einer Beschichtungsausdünnung gemäss der EP-0 352 545 nur in wenigen Einsatzbereichen der spanenden Bearbeitung bessere oder zumindest gleich gute Ergebnisse erzielt werden können, verglichen mit dem Einsatz von entsprechenden Werkzeugen mit einem geringeren oder gar keinem, zumindest nicht messbaren, Konzentrationsunterschied an der Hartstoffschicht. Insbesondere ist zu bemerken, dass das in der EP-0 532 545 erwähnte Beispiel bezüglich Standzeit von Spiralbohrern, aufgrund der entsprechend vorliegender Erfindung gemachten repräsentativen Vergleiche, zumindest dann falsch ist, wenn zwei bis auf den erwähnten Beschichtungsunterschied völlig gleiche und gleichartig beschichtete Bohrer vorliegen. Völlig gleichartig heisst dabei Einsatz desselben Beschichtungsverfahrens, insbesondere Arc- oder Sputterverfahrens, an identischen Werkzeugkörpern, wobei die Einstellung des realisierten bzw. nichtrealisierten Konzentrationsunterschiedes ausschliesslich durch Einstellung der an den Werkzeug-Grundkörper während der Beschichtung angelegten Spannung bezüglich Masse-bzw. Bezugspotential, im weiteren Biasspannung $U_{BIAS}$ genannt, und/oder des Reaktivgas-Partialdruckes $p_{reaktiv}$ im Vakuumbeschichtungsrezipienten erfolgt, bei unveränderten weiteren Prozessparametern.

Dass die vorbekannte Ausdünnung im Wirkungskantenbereich massgebliche Nachteile im Werkzeugeinsatz bewirken kann, und dass mithin erfindungsgemäss sehr sorgfältig abgewägt werden muss, welches Verfahren wann eingesetzt wird, kann beispielsweise daran erkannt werden, dass gerade die Aluminiumverarmung der Hartstoffschicht im Wirkungskantenbereich negative Auswirkungen auf den Verschleiss durch thermische Beanspruchung der Hartstoffschicht nach sich zieht, da durch die Aluminiumausdünnung unter Umständen nurmehr wenig Aluminium durch Diffusion an die Hartstoffschicht-Oberfläche gelangt und sich dort keine durchgehende thermisch isolierende Aluminiumoxid-Schicht bilden kann. Die $Al_2O_3$-Schicht an der Oberfläche wird während des Bearbeitungsprozesses gleichzeitig verschlissen und durch Al-Diffusion nachgebildet. Gerade dieses Phänomen aber kann die Beständigkeit einer vorgesehenen Hartstoffschicht mit Aluminiumkomponente unter gewissen Einsatzbedingungen massgeblich beeinflussen.

Erfindungsgemäss und wie in den nachfolgenden Beispielen dargelegt, konnte gezeigt werden, dass Werkzeuge mit einer Hartstoffschicht, insbesondere einer (Ti,Al)N-Schicht, mindestens umfassend eine nur kleine oder nicht mehr messbare Zusammensetzungs-Änderung des Hartstoffschichtmaterials im Wirkungskantenbereich, in vielen Anwendungsfällen eine wesentlich bessere Standzeit, gar bei erhöhter Schnittleistung erbringen als andere, sonst gleiche Werkzeuge mit Zusammensetzungs-Änderung der Hartstoffschicht im Wirkungskantenbereich. Besonders gute Ergebnisse sind dabei zu erzielen, im ersterwähnten Fall, wenn im Wirkungskantenbereich die Änderung einer der Hartstoffschicht-Metallkomponenten weniger als 2 at% beträgt, bevorzugt höchstens 1 at% bzw. nicht mehr messbar ist.

Dem Wortlaut von Anspruch 3 folgend, wird bei Einsatz von Arcverdampfen zum Ablegen der Hartstoffschicht, im Wirkungskantenbereich eine möglichst unveränderte Hartstoffschicht-Zusammensetzung dadurch erreicht, dass für das Verhältnis $U_{BIAS}$ - der elektrischen Werkzeug-Grundkörperspannung gegenüber Bezugspotential, üblicherweise Massepotential, - zu Reaktivgas-Partialdruck $p_{reaktiv}$ folgender Bereich eingehalten wird:

$$1 \times 10^{-3} \leq U_{BIAS}/p_{reaktiv} \leq 4 \times 10^{3},$$

dabei mit der Spannungseinheit "Volt" und der Druckeinheit "mbar".

Im weiteren werden insbesondere und dem Wortlaut von Anspruch 4 folgend, Bohrer, Schruppfräser, Umfangfräser und Wälzfräser mit möglichst unveränderter Hartstoffschicht-Zusammensetzung im Wirkungskantenbereich realisiert, hingegen Stirnfräser und Kugelkopffräser mit im Wirkungskantenbereich veränderter Hartstoffschicht-Zusammensetzung.

Insbesondere wurde befunden, dass man, dem Wortlaut von Anspruch 5 folgend, die Hartstoffschicht-Zusammensetzung im Wirkungskantenbereich der Werkzeuge möglichst unverändert realisieren soll, wenn diese Werkzeuge für die Bearbeitung bei verhältnismässig grossen Spannungsquerschnitten und bei kleinen Schnittgeschwindigkeiten vorgesehen sind, dass man hingegen Werkzeuge mit veränderter Hartstoffschicht-Zusammensetzung im Wirkungskantenbereich bereiten soll, wenn letztere für verhältnismässig geringe Spannungsquerschnitte, aber relativ grosse Schnittgeschwindigkeiten vorgesehen sind.

Ein weiteres Kriterium für die erfindungsgemässe Selektion der Hartstoffbeschichtungsart im Wirkungskantenbereich der Werkzeuge ergibt sich, dem Wortlaut von Anspruch 6 folgend, dadurch, dass man für die Bearbeitung von Werkstoffen mit einer Härte bis höchstens 45 Rockwell (HRC) und einer Zugfestigkeit bis höchstens 1500 $N/mm^2$, dabei bevorzugt für die Bearbeitung von Vergütungsstählen, hochlegierten und rostfreien Stählen sowie von Nichteisenmetallen, die Hartstoffbeschichtung im Wirkungskantenbereich möglichst ohne Zusammensetzungsänderung vornimmt. Dasselbe gilt gemäss Wortlaut von Anspruch 7 für Werkzeuge, deren wirkungskanten im Einsatz gleichzeitig unterschiedlichen Schnittgeschwindigkeiten unterzogen werden, wie insbesondere für Bohrer, woran eine minimale Schnittgeschwindigkeit an der Bohrerspitze auftritt und diesbezüglich eine hohe am Bohrerumfang.

Dem Wortlaut von Anspruch 8 folgend, werden Werkzeug-Grundkörper im Wirkungskantenbereich mit veränderter Hartstoffschicht-Zusammensetzung beschichtet, die für die spanende Bearbeitung von Werkstoffen mit einer Härte von mehr als 45 Rockwell (HRC) und mit einer Zugfestigkeit von mehr als 1500 $N/mm^2$, insbesondere für Hartzerspan-Operationen, vorgesehen sind, z.B. anstelle von Schleif- oder Erosionsverfahren.

Dem Wortlaut von Anspruch 9 folgend, wurde nun insbesondere erkannt, dass

- Wendeschneidplatten für Drehmesser und für zu bearbeitende Materialien AISI 304SS bzw. DIN 1.4306,
- Wendeschneidplatten für Umfangsfräser, für zu bearbeitende Materialien AISI 4140 bzw. DIN 1.7225,
- Wendeschneidplatten SEE 42TN für Fräser für zu bearbeitendes Material SKD 61 (HRC 45)
- Hartmetall-Schrupp-Schaftfräser für zu bearbeitende Materialien DIN 1.2344, bei Trockenbearbeitung sowie
- HSS-Bohrer für zu bearbeitende Materialien AISI D3 bzw. DIN 1.2080 sowie GG 25 mit Emulsionsschmierung

mit möglichst unveränderter Hartstoffschicht-Zusammensetzung im Wirkungskantenbereich realisiert werden sollen, hingegen

- Hartmetall-Schrupp-Schaftfräser für zu bearbeitende Materialien DIN 1.2311, mit Emulsionsschmierung
- Hartmetall-Stirnfräser für zu bearbeitendes Material AISI D2 bzw. DIN 1.237
- Hartmetall-Kugelkopffräser J97 für Trockenbearbeitung von DIN 1.2343, 49.5 HRC, bevorzugt mit im Wirkungskantenbereich veränderter Hartstoffschicht-Zusammensetzung.

Ein erfindungsgemässer Werkzeugsatz ist weiter in Anspruch 10 spezifiziert. Dabei sind mindestens zwei Werkzeuge vorgesehen, eines für eine erste bestimmte Einsatz-Operation, wo primär hohe Haftfestigkeit der Hartstoffschicht gefordert ist, jedoch nur sekundär eine hohe Härte der Hartstoffschicht und ein zweites, bei dessen Einsatz primär eine hohe Härte der Hartstoffschicht gefordert ist und nur sekundär eine hohe Haftfestigkeit dieser Schicht.

An diesem erfindungsgemässen Werkzeugsatz ist das erste Werkzeug im Wirkungskantenbereich mit im wesentlichen gleichbleibender Zusammensetzung der Hartstoffschicht beschichtet, hingegen das zweite mit veränderter Hartstoffschicht-Zusammensetzung.

Weitere bevorzugte Ausführungsformen des erfindungsgemässen Werkzeugsatzes sind in den Ansprüchen 11 bis 18 spezifiziert.

Ob ein Werkzeug mit einer Hartstoffbeschichtung versehen ist, deren Zusammensetzung im Wirkungskantenbereich verändert ist oder nicht, zeigt sich oft an der Beschichtungsverfärbung des Werkzeuges im Wirkungskantenbereich, so typischerweise für (Ti,Al)N-Schichten mit Al-Verarmung, im Wirkungskantenbereich durch dessen Gelb- bzw. Rötlichfärbung im erwähnten Bereich.

Durch die vorliegende Beschreibung und die Ansprüche erhält der einschlägige Fachmann klar Anweisungen, aufgrund welcher Kriterien er untersuchen soll, welche Wirkungskanten-Hartstoffbeschichtungstechniken zu besserem Werkzeugeinsatz-Verhalten führen. Auch wenn in Beschreibung und Ansprüchen spezifische Werkzeugtypen sowie deren Einsatzart und die zu bearbeitenden Materialien spezifiziert sind, so ist dies für den Fachmann nicht abschliessend zu verstehen, sondern er erkennt bei der Evaluation der zweckmässigen Beschichtungsart für weitere Werkzeuge, für weitere Einsatzgebiete und Werkstoffe, aus Analogiebetrachtungen, welche Beschichtungstechnik einzusetzen ist oder erhält den Hinweis, erst überhaupt zu versuchen, welche der beiden Beschichtungstechniken zu besseren Resultaten führt.

Die Erfindung wird anschliessend anhand von Beispielen und, im Zusammenhang damit, von Figuren erläutert. Die Figuren zeigen:

Fig. 1 ein Auger-Linienscan-Diagramm, aufgenommen im Wirkungskantenbereich, als Beispiel an einer Wendeschneidplatte des Typs SNGA 120408, im rechten Winkel zur Wirkungskante. Die Titan- und Aluminium-Verteilung ist erkenntlich gleichbleibend, entsprechend unveränderter Hartstoffschicht-Zusammensetzung im Wirkungskantenbereich,

Fig. 2 ein am gleichen Objekt wie Fig. 1 aufgenommenes AugerLinienscan, woran jedoch die Titan- und Aluminiumverteilung im Wirkungskantenbereich veränderte Zusammensetzung des Hartstoffschicht-Materials zeigt,

Fig. 3 vereinfacht und schematisch, die Aufsicht auf eine für die beschriebenen Versuche eingesetzte Anlage.

In den erläuterten Beispielen wurden jeweils identische Werkzeug-Grundkörper mittels Arcverdampfen beschichtet. In den Beispielen 1 bis 4 wurden die nachfolgend mit A und B spezifizierten Beschichtungsbedingungen gewählt. Die Schichtdicke, insbesondere im Wirkungskantenbereich, betrug dabei ca. 3,5 µm.

Die unter A realisierten Beschichtungen zeigen dabei eine gleichmässige Titan- bzw. Aluminiumverteilung gemäss AugerLinienscan von Fig. 1 auf. Dieser wurde an der Kante eines nach A beschichteten Wendeschneidplättchens Typ SNGA 120408 beginnend, im rechten Winkel zur Wirkungskante bzw. der polierten Spanfläche, auf einer Länge von 0,5 mm aufgenommen, entsprechend ca. 60 Messpunkten pro Scan. Die Härte der Schichten realisiert unter A betrug ca. 3000 $HV_{0.05}$.

Die unter B beschriebenen Parameter ergeben Schichten, die im Wirkungskantenbereich eine starke Verarmung des Aluminiums aufweisen, nämlich von 50 at% (an der Kante) auf 40 at%, bzw. eine Anreicherung des Titans von 50 at% (an der Kante) auf 60 at%, gemäss Fig. 2. Bei schärfer ausgeprägten Kanten, wie beispielsweise bei Messerschneiden, konnten noch deutlich grössere Unterschiede in der Hartschicht-Materialzusammensetzung gemessen werden. Die Härte der unter B abgeschiedenen Schichten liegt bei ca. 3'500 $HV_{0.05}$. In den nachfolgenden Tabellen sind die beiden Parametersätze A und B für das Arcverdampfungsbeschichten zusammengestellt.

Alle Versuche wurden auf einer Anlage BAJ 1200 unter Produktionsbedingungen durchgeführt.

In Fig. 3 ist schematisch die Aufsicht auf eine Anlage der genannten Art dargestellt. In einer zylindrischen Behandlungskammer 1 ist bezüglich der Zentralachse $A_1$, wie mit der Drehbewegung $\omega_1$ dargestellt, ein Karussell drehbeweglich gelagert. Auf dem Karussell sind mehrere Substratträgeranordnungen 3 jeweils um Achsen $A_2$ drehbeweglich gelagert, wie mit der Drehbewegung $\omega_2$ dargestellt ist. Auf den Substratträgeranordnungen 3 sind, gruppiert um die jeweilige Achse $A_2$, in einzelnen Substratträgern, die Substrate 5 gelagert, welche bevorzugterweise selber und wie mit $\omega_3$ dargestellt um ihre Eigenachse getrieben in Drehbewegung versetzt werden.

An der Wandung der Kammer 1 sind eine oder mehrere Arcverdampferquellen 7 angeflanscht. Bezüglich detaillierterem Aufbau der eingesetzten Anlage wird beispielsweise auf die US-A-5 709 784 derselben Anmelderin verwiesen.

Bei den Versuchen wurde ausschliesslich $N_2$-Gas eingesetzt, d.h. sowohl als Arbeits- wie auch als Reaktivgas. Es versteht sich von selber, dass zusätzlich auch ein Edelgas, insbesondere Argon, als Arbeitsgas eingesetzt werden kann. Für die Beschichtung des Typs A war der Totaldruck, d.h. der $N_2$-Druck, ca. 3 x $10^{-2}$ mbar, für die Versuche B ca. 1 x $10^{-2}$ mbar.

Es wurde T, Al aus Legierungstargets arcverdampft.

In den nachfolgenden Tabellen bezeichnen weiter:

$p_{N2}$: Partialdruck des Reaktivgases $N_2$

$I_{Ti}$: Bogenstrom beim Titanverdampfen

$I_{TiAl}$: Bogenstrom beim TiAl-Legierungsverdampfen

| Beschichtungsparameter A: | | | |
|---|---|---|---|
| **Parameter** | | **TiN-Zwischenschicht** | **(TiAl)N-Hartstoffschicht** |
| $p_{N2}$ | [mbar] | 8 x $10^{-3}$ | 3,2 x $10^{-2}$ |
| $I_{ti}$ | [A] | 170 | 0 |
| $I_{TiAl}$ | [A] | 0 | 200 |
| $U_{BIAS}$ | [V] | -200 | -40 |

| Beschichtungsparameter B: | | | |
|---|---|---|---|
| **Parameter** | | **TiN-Zwischenschicht** | **(TiAl)N-Hartstoffschicht** |
| $p_{N2}$ | [mbar] | 8 x $10^{-3}$ | 1 x $10^{-2}$ |
| $I_{Ti}$ | [A] | 170 | 0 |
| $I_{TiAl}$ | [A] | 0 | 200 |
| $U_{BIAS}$ | [V] | -150 | -150 |

In allen Fällen wurde zwischen Werkzeug-Grundkörper und Hartstoffschicht eine TiN-Zwischenschicht eingebaut.

Beispiel 1

| | |
|---|---|
| Werkzeug: | Drehmesser mit Wendeschneidplatte K313/CNGP432 |
| bearbeitetes Material: | AISI 304SS ≅ DIN 1.4306 |
| Schnittgeschwindigkeit: | $v_c$ = 244 m/min |
| Vorschub je Umdrehung: | $f_U$ = 0.2 mm/U |
| Schnitttiefe: | $a_p$ = 1.524 mm |
| Schmiermittel: | Emulsion |

| Versuchsnr. | Schicht | Bearbeitungszyklen | Zyklen-Durchschnitt |
|---|---|---|---|
| 1 | TiN | 7.5 | 6.8 |
| 2 | | 6.5 | |
| 3 | | 6.5 | |
| 4 | TiAlN "A" | 21.0 | 18.3 |
| 5 | | 17.0 | |
| 6 | | 17.0 | |
| 7 | TiAlN "B" | 6.4 | 5.8 |
| 8 | | 5.5 | |
| 9 | | 5.5 | |

Beispiel 2

| | |
|---|---|
| Werkzeug: | Umfangfräser mit Wendeschneidplatte K903/SEHW43A6T |
| bearbeitetes Material: | AISI 4140 ≅ DIN 1.7225 |
| Schnittgeschwindigkeit: | $v_c$ = 1152 m/min |
| Vorschub je Umdrehung: | $f_t$ = 0.25 mm/U |
| Schnitttiefe: | $a_p$ = 2.54 mm |
| Schmiermittel: | Emulsion |

| Versuchsnr. | Schicht | Bearbeitungszyklen | Zyklen-Durchschnitt |
|---|---|---|---|
| 10 | TiN | 15.0 | 14.8 |
| 11 | | 13.0 | |
| 12 | | 15.5 | |
| 13 | | 15.5 | |

(fortgesetzt)

| Versuchsnr. | Schicht | Bearbeitungszyklen | Zyklen-Durchschnitt |
|---|---|---|---|
| 14 | TiAlN "A" | 37.0 | 24.8 |
| 15 | | 19.0 | |
| 16 | | 21.5 | |
| 17 | | 21.5 | |
| 18 | TiAlN "B" | 13.0 | 12 |
| 19 | | 11.0 | |
| 20 | | 12.0 | |
| 21 | | 12.0 | |

Beispiel 3

Werkzeug: HSS-Bohrer, 6 mm

bearbeitetes Material: AISI D3 ≅ DIN 1.2080

Schnittgeschwindigkeit: $v_c$ = 35 m/min

Vorschub je Umdrehung: $f_u$ = 0.12 mm/U

Eingriffsgrösse: $a_e$ = 3 mm

Bohrtiefe: h = 15 mm, Sackloch

Schmiermittel: 5 % Emulsion

| Versuchsnr. | Schicht | Durchschnittliche Lochzahl |
|---|---|---|
| 28 | TiN | 45 |
| 29 | TiCN | 85 |
| 30 | TiAlN "A" | 190 |
| 31 | TiAlN "B" | 30 |

Die Beispiele 1, 2 und 3 zeigen, dass für bestimmte Werkzeuge und Einsatzbedingungen eine im Wirkungskantenbereich veränderte Hartstoffzusammensetzung, insbesondere Verarmung an Al, zu markant schlechteren Standzeiten führt als eine unveränderte Hartstoffschichtzusammensetzung.

Beispiel 4a

Werkzeug: Hartmetall-Schrupp-Schaftfräser, ∅ = 10 mm, 25/64

Zahnzahl: z = 4

bearbeitetes Material: DIN 1.2344, 55-56 HRC

Schnittgeschwindigkeit: $v_c$ = 50 m/min

Vorschub je Umdrehung: $f_t$ = 0.02 mm/Zahn

Eingriffsgrösse: $a_e$ = 2 mm

Schnitttiefe: $a_p$ = 10 mm

Schmiermittel: trocken, Pressluftkühlung

| Versuchsnr. | Schicht | Verschleissbreite in μm nach x Operationen | | | |
|---|---|---|---|---|---|
| | | x = 10 | x = 20 | x = 30 | x = 35 |
| 22 | TiAlN "A" | 45 | 54 | 65 | 70 |
| 23 | TiAlN "B" | 50 | 69 | 80 | 88 |

Dieses Beispiel zeigt besonders harte Einsatzbedingungen, da hartes Material trocken bearbeitet wird. Die mit den Parametern A beschichteten Werkzeuge und mithin Werkzeuge mit unveränderter Zusammensetzung der Hartstoffschicht im Wirkungskantenbereich zeigen dabei markant geringere Verschleissmarkenbreiten auf als Werkzeuge mit im Wirkungskantenbereich veränderter Hartstoffschicht-Zusammensetzung.

Beispiel 4b

Werkzeug: Hartmetall-Schrupp-Schaftfräser, ∅ = 10 mm, 25/64

Zahnzahl: z = 3

bearbeitetes Material: DIN 1.2311, 33 HRC, Rm = 1050 $N/mm^2$

Schnittgeschwindigkeit: $v_c$ = 100 m/min

Vorschub je Umdrehung: $f_t$ = 0.035 mm/Zahn

Eingriffsgrösse: $a_e$ = 3 mm

Schnitttiefe: $a_p$ = 16 mm

Schmiermittel: 5 % Emulsion

| Versuchsnr. | Schicht | Durchschnittliche Weglänge |
|---|---|---|
| 24 | TiN | 24 |
| 25 | TiCN | 27 |
| 26 | TiAlN "A" | 42 |
| 27 | TiAlN "B" | 78 |

Aus diesem Beispiel ist ersichtlich, dass bei hoher Schnittgeschwindigkeit und zusätzlicher Emulsionsschmierung, weiter bei relativ weichem zu bearbeitenden Material, mit der Beschichtungstechnik entsprechend B höhere durchschnittliche Weglängen erzielt werden.

Die Beispiele 4a und 4b zeigen mithin, dass bei ähnlichen Operationen, jedoch unterschiedlichen Einsatzbedingungen, im Wirkungskantenbereich unterschiedlich beschichtete gleiche Werkzeuge jeweils vorteilhaft sind.

In den nachfolgenden Beispielen 5 bis 9 sind weitere Werkzeuge spezifiziert mit den jeweils gültigen Beschichtungsparametern in Analogie zu A und B. Es sind diejenigen Werkzeuge mit konstanter Zusammensetzung der Hartstoffschicht im Wirkungskantenbereich mit $A_c$ bezeichnet, analog Werkzeuge mit im Wirkungskantenbereich ver-

änderter Harstoffschicht-Zusammensetzung mit $B_o$. Weiterhin wurden, abgesehen von den spezifizierten Beschichtungsparametern, identische Werkzeug-Grundkörper mit identischen Beschichtungsverfahren beschichtet und miteinander bezüglich ihrer Standzeiten verglichen.

Beispiel 5

| | |
|---|---|
| Werkzeug: | Fräser mit Wendeschneidplatten SEE 42 TN (G9) |
| Zahnzahl: | z = 6 |
| Schichtdicke $(Ti_xAl_y)N$: | jeweils 4.5 µm |
| bearbeitetes Material: | SKD 61 (HRC45) |
| Schnittgeschwindigkeit: | $v_c$ = 100 m/min |
| Vorschub je Zahn: | $f_z$ = 0.1 mm/Zahn |
| Schnitttiefe: | $a_p$ = 2 mm |

| Proben | Nr. | Beschichtungsbedingungen | | | Al-Abnahme zur Kante | Schnittlänge |
|---|---|---|---|---|---|---|
| | | Bias [-V] | N2 [$10^{-2}$ mbar] | Bogenstrom [A] | [at%] | [m] |
| $A_o$ | 32 | 60 | 2.5 | 150 | 1 | 3.2 |
| | 33 | 60 | 3.2 | 150 | 1 | 3.0 |
| | 34 | 40 | 2.0 | 150 | 0 | 8.8 |
| | 35 | 40 | 4.0 | 150 | 0 | 3.9 |
| | 36 | 40 | 0.5 | 150 | 0 | 2.0 |
| | 37 | 30 | 2.0 | 150 | 0 | 4.2 |
| $B_o$ | 38 | 100 | 2.0 | 150 | 4 | 1.1 |
| | 39 | 150 | 3.0 | 150 | 7 | 1.1 |
| | 40 | 150 | 2.0 | 150 | 4 | 0.5 |

Beispiel 6

| | |
|---|---|
| Werkzeug: | HSS-Bohrer, ∅ 6 mm |
| Schichtdicke $(Ti_xAl_y)N$: | jeweils 5 µm |
| Zwischenschicht TiN: | jeweils 0.5 µm |
| bearbeitetes Material (mit Emulsion): | DIN 1.2080 (AISI D3) |
| Schnittgeschwindigkeit: | $v_c$ = 40 m/min |
| Vorschub: | f = 0.10 mm/Umdrehung |
| Bohrtiefe: | 15 mm (Blindloch) |

| Proben | Nr. | Beschichtungsbedingungen | | | Al-Abnahme zur Kante [at%] | Anzahl Bohrlöcher |
|---|---|---|---|---|---|---|
| | | Bias [-V] | N2 [$10^{-2}$ mbar] | Bogenstrom [A] | | |
| $A_o$ | 41 | 40 | 3.0 | 200 | 0 | 198 |
| | 42 | 40 | 3.0 | 200 | 0 | 231 |
| $B_o$ | 43 | 150 | 1.0 | 200 | 7 | 45 |
| | 44 | 150 | 1.0 | 200 | 7 | 38 |

Beispiel 7

| | |
|---|---|
| Werkzeug: | HSS-Schruppfräser, ∅ 12 mm |
| Zahnzahl: | z = 4 |
| Schichtdicke $(Ti_xAl_y)N$: | jeweils 4.5 µm |
| Zwischenschicht TiN: | jeweils 0.3 µm |
| trocken bearbeitetes Material: | DIN 1.2344 (AISI H13) |
| Schnittgeschwindigkeit: | $v_c$ = 120 m/min |
| Vorschub je Zahn: | $f_z$ = 0.6 mm/Zahn |
| Schnitttiefe: | $a_p$ = 20 mm |
| Eingriffsgrösse: | $a_e$ = 5 mm |

| Proben | Nr. | Beschichtungsbedingungen | | | Al-Abnahme zur Kante [at%] | Schnittlänge [m] |
|---|---|---|---|---|---|---|
| | | Bias [-V] | N2 [$10^{-2}$ mbar] | Bogenstrom [A] | | |
| $A_o$ | 45 | 40 | 2.5 | 200 | 0 | 41 |
| $B_o$ | 46 | 150 | 1.0 | 200 | 7 | 12 |

Beispiel 8

| | |
|---|---|
| Werkzeug: | Hartmetall-Bohrer, ∅ 11.8 mm |
| Schichtdicke $(Ti_xAl_y)N$: | jeweils 5 µm |
| Zwischenschicht TiN: | jeweils 0.5 µm |
| mit Emulsion bearbeitetes Material: | GG 25 (Grauguss) |
| Schnittgeschwindigkeit: | $v_c$ = 110 m/min |
| Vorschub: | f = 0.4 mm/Umdrehung |
| Bohrtiefe: | 35 mm (Blindloch) |

| Proben | Nr. | Beschichtungsbedingungen | | | Al-Abnahme zur Kante [at%] | Anzahl Bohrlöcher |
|---|---|---|---|---|---|---|
| | | Bias [-V] | N2 [$10^{-2}$ mbar] | Bogenstrom [A] | | |
| $A_o$ | 47 | 40 | 3.0 | 200 | 0 | 2840 |
| $B_o$ | 48 | 150 | 1.1 | 200 | 7 | 1270 |

Beispiel 9

| | |
|---|---|
| Werkzeug: | HM-Wendeschneidplatte, Aussenrunddrehen |
| Schichtdicke $(Ti_xAl_y)N$: | jeweils 5 µm |
| Zwischenschicht TiN: | jeweils 0.2 µm |
| mit Schmierung bearbeitetes Material: | DIN 1.4306 (X2CrNi 1911) |
| Schnittgeschwindigkeit: | $v_c$ = 240 m/min |
| Vorschub pro Umdrehung: | f = 0.6 mm |
| Schnitttiefe: | $a_p$ = 1.5 mm |

| Proben | Nr. | Beschichtungsbedingungen | | | Al-Abnahme zur Kante [at%] | Schnittlänge [m] |
|---|---|---|---|---|---|---|
| | | Bias [-V] | N2 [$10^{-2}$ mbar] | Bogenstrom [A] | | |
| $A_o$ | 49 | 40 | 3.0 | 200 | 0 | 4.732 |
| $B_o$ | 50 | 150 | 1.0 | 200 | 7 | 2.015 |

Die Beispiele 5 bis 9 zeigen die Überlegenheit von Werkzeugen mit unveränderter Hartstoffschicht-Zusammensetzung im Wirkungskantenbereich in unterschiedlichen spezifischen Anwendungen.

Beispiel 10

| | |
|---|---|
| Werkzeug: | Hartmetallstirnfräser, ∅ 10 mm |
| Zahnzahl: | z = 6 |
| Schichtdicke $(Ti_xAl_y)N$: | jeweils 3.5 µm |
| trocken bearbeitetes Material: | AISI D2 (DIN 1.2379), 60 HRC |
| Schnittgeschwindigkeit: | $v_c$ = 20 m/min |
| Vorschub je Zahn: | $f_z$ = 0.035 mm/Zahn |
| Schnitttiefe: | $a_p$ = 15 mm |
| Eingriffsgrösse: | $a_e$ = 1 mm |

| Proben | Nr. | Beschichtungsbedingungen | | | Al-Abnahme zur Kante [at%] | Schnittlänge [m] |
|---|---|---|---|---|---|---|
| | | Bias [-V] | N2 [$10^{-2}$ mbar] | Bogenstrom [A] | | |
| $A_o$ | 51 | 40 | 3.0 | 200 | 0 | 4 |
| | 52 | 40 | 2.0 | 200 | 0 | 2 |
| | 53 | 20 | 2.0 | 200 | 0 | 3 |
| | 54 | 70 | 3.0 | 200 | 1.5 | 12 |
| $B_o$ | 55 | 200 | 3.0 | 200 | 9 | 21 |
| | 56 | 150 | 2.0 | 200 | 7 | 29 |
| | 57 | 100 | 1.0 | 200 | 4 | 17 |
| | 58 | 100 | 2.0 | 200 | 4 | 22 |

Beispiel 11

Werkzeug: Hartmetallstirnfräser, ∅ 10 mm

Zahnzahl: z = 6

Schichtdicke $(Ti_xAl_y)N$: jeweils 3.5 µm

Zwischenschicht TiN: jeweils 0.1 µm

bearbeitetes Material: DIN 1.2379 (AISI D2), 60 HRC

Schnittgeschwindigkeit: $v_c$ = 20 m/min

Vorschub je Zahn: $f_z$ = 0.03 mm/Zahn

Schnitttiefe: $a_p$ = 15 mm

Eingriffsgrösse: $a_e$ = 1 mm

| Proben | Nr. | Beschichtungsbedingungen | | | Al-Abnahme zur Kante [at%] | Schnittlänge [m] |
|---|---|---|---|---|---|---|
| | | Bias [-V] | N2 [$10^{-2}$ mbar] | Bogenstrom [A] | | |
| $A_o$ | 55 | 40 | 3.5 | 200 | 0 | 22 |
| $B_o$ | 56 | 150 | 1.0 | 200 | 7 | 31 |

Beispiel 12

Werkzeug: Hartmetallkugelkopffräser J97 (Jabro), R4 (∅ 8 x 65 mm)

Schichtdicke $(Ti_xAl_y)N$: jeweils 3.5 µm

Zwischenschicht TiN: jeweils 0.1 µm

| | |
|---|---|
| trocken bearbeitetes Material: | DIN 1.2343, 49.5 HRC |
| Schnittgeschwindigkeit: | $v_c$ = 240 m/min |
| Schnitttiefe: | $a_p$ = 0.5 mm |

| Proben | Nr. | Beschichtungsbedingungen | | | Al-Abnahme zur Kante [at%] | Schnittlänge [m] |
|---|---|---|---|---|---|---|
| | | Bias [-V] | N2 [$10^{-2}$ mbar] | Bogenstrom [A] | | |
| $A_o$ | 57 | 40 | 3.0 | 200 | 0 | 111 |
| $B_o$ | 58 | 150 | 1.0 | 200 | 7 | 168 |

Die Beispiele 10 bis 12 zeigen, dass bei gewissen Einsatzbedingungen und Werkzeugen die Standzeiten erhöht werden, wenn die Hartmetallschicht-Zusammensetzung im Wirkungskantenbereich verändert wird.

## Patentansprüche

1. Verfahren zum Schutzbeschichten von spanenden Werkzeugen, bei dem man auf den Werkzeug-Grundkörper, mittels eines Plasma-Vakuumbeschichtungsverfahrens, eine Hartstoffschicht aufbringt und bei dem man, Werkzeug-beanspruchungs-spezifisch, die Hartstoffschicht-Zusammensetzung im Wirkungskantenbereich gegenüber der Hartstoffschicht-Zusammensetzung in übrigen Beschichtungsbereichen am Werkzeug-Grundkörper

   (a) möglichst unverändert belässt, oder

   (b) gezielt verändert,

   und zwar ersteres (a), wenn das Werkzeug primär Forderungen an die Haftfestigkeit der Hartstoffschicht und nur sekundär an die Härte der Hartstoffschicht stellt, zweiteres (b), wenn das Werkzeug primär Forderungen an die Härte der Hartstoffschicht und nur sekundär an die Haftfestigkeit der Hartstoffschicht am Grundkörper stellt.

2. Verfahren nach Anspruch 1, dadurch gekennzeichnet, dass man mindestens als Teil der Hartstoffschicht eine (Ti, Al)N-Schicht auf den Werkzeuggrundkörper aufbringt, vorzugsweise mit einer Zwischenschicht.

3. Verfahren nach einem der Ansprüche 1 oder 2, dadurch gekennzeichnet, dass die Hartstoffschicht durch Arc-Verdampfen abgelegt wird und vorzugsweise (a) im Wirkungskantenbereich eine möglichst unveränderte Hartstoffschicht-Zusammensetzung dadurch erreicht wird, dass für das Verhältnis $U_{BIAS}$, der Werkzeuggrundkörperspannung bezüglich Bezugs-, vorzugsweise Massepotential, zu Reaktivgas-Partialdruck, $p_{reaktiv}$, folgender Bereich eingehalten wird:

   $$1 \times 10^3 \leq U_{BIAS}/P_{reaktiv} \leq 4 \times 10^3,$$

   mit [Volt] als Spannungseinheit und [mbar] als Druckeinheit.

4. Verfahren nach einem der Ansprüche 1 bis 3, dadurch gekennzeichnet, dass man mit (a) möglichst unveränderter Hartstoffschicht-Zusammensetzung im Wirkungskantenbereich Werkzeug-grundkörper von
   ($a_1$) Bohrern, Schruppfräsern, Umfangfräsern, Wälzfräsern, Drehmessern realisiert,
   dass man (b) die Hartstoffschicht-Zusammensetzung im Wirkungskantenbereich verändert für Werkzeug-Grundkörper von
   ($b_1$) Stirnfräsern und Kugelkopffräsern.

5. Verfahren nach einem der Ansprüche 1 bis 4, dadurch gekennzeichnet, dass man die Hartstoffschicht-Zusammensetzung (a) im Wirkungskantenbereich möglichst unverändert belässt bei der Beschichtung von Grundkörpern von Werkzeugen für die Bearbeitung bei verhältnismässig grossen Spannungsquerschnitten und bei kleinen Schnittgeschwindigkeiten, jedoch die Grundkörper (b) mit veränderter Hartstoffschicht-Zusammensetzung im Wirkungskantenbereich beschichtet von Werkzeugen für verhältnismässig geringe Spannungsquerschnitte, aber relativ grosse Schnittgeschwindigkeiten.

**6.** Verfahren nach einem der Ansprüche 1 bis 5, dadurch gekennzeichnet, dass man (a) Werkzeug-Grundkörper mit im Wirkungskantenbereich möglichst unveränderter Hartstoffschicht-Zusammensetzung beschichtet für die Bearbeitung von Werkstoffen mit einer Härte bis höchstens 45 Rockwell (HRC) und einer Zugfestigkeit bis höchstens 1500 $Nmm^{-2}$, vorzugsweise für die Bearbeitung von Vergütungsstählen sowie von hochlegierten und von rostfreien Stählen sowie von Nichteisenmetallen.

**7.** Verfahren nach einem der Ansprüche 1 bis 6, dadurch gekennzeichnet, dass man (a) Werkzeug-Grundkörper im Wirkungskantenbereich mit möglichst unveränderter Hartstoffschicht-Zusammensetzung beschichtet, wenn die Werkzeuge mit ihrer Wirkungskante gleichzeitig mit unterschiedlicher Schnittgeschwindigkeit beansprucht werden, wie insbesondere Bohrer mit minimaler Schnittgeschwindigkeit an der Bohrerspitze und diesbezüglich hoher Schnittgeschwindigkeit am Bohrerumfang.

**8.** Verfahren nach einem der Ansprüche 1 bis 7, dadurch gekennzeichnet, dass Grundkörper im Wirkungskantenbereich mit veränderter Hartstoffschicht-Zusammensetzung beschichtet werden von Werkzeugen, die für spanende Bearbeitung von Werkstoffen mit einer Härte von mehr als 45 Rockwell (HRC) und mit einer Zugfestigkeit von mehr als 1500 $Nmm^{-2}$, insbesondere für Hartzerspanen, vorgesehen sind.

**9.** Verfahren nach einem der Ansprüche 1 bis 8, dadurch gekennzeichnet, dass die Werkzeug-Grundkörper im Wirkungskantenbereich mit möglichst unveränderter Hartstoffschicht-Zusammensetzung beschichtet werden an:

- Wendeschneidplatten für Drehmesser und zu bearbeitendes Material AISI 304SS bzw. DIN 1.4306
- Wendeschneidplatten für Umfangfräser für zu bearbeitendes Material AISI 4140 bzw. DIN 1.7225
- Wendeschneidplatten SEE 42TN für Fräser für zu bearbeitendes Material SKD 61 (HRC 45)
- Hartmetall-Schrupp-Schaftfräser für zu bearbeitendes Material DIN 1.2344, bei Trockenbearbeitung,
- HSS-Bohrer für zu bearbeitendes Material AISI D3 bzw. DIN 1.2080 sowie GG25 mit Emulsionsschmierung,

hingegen die Werkzeug-Grundkörper im Wirkungskantenbereich mit veränderter Zusammensetzung hartstoffbeschichtet werden an:

- Hartmetall-Schrupp-Schaftfräser für zu bearbeitendes Material DIN 1.2311, mit Emulsionsschmierung,
- Hartmetall-Stirnfräser für zu bearbeitendes Material AISI D2 bzw. DIN 1.2379
- Hartmetall-Kugelkopffräser J97 (Jabro) für Trockenbearbeitung von DIN 1.2343, 49.5 HRC.

**10.** Werkzeugsatz mit mindestens zwei hartstoffbeschichteten Werkzeugen, wobei die Hartstoffschicht vorzugsweise eine (Ti,Al)N-Schicht umfasst und mindestens eines der Werkzeuge für eine spanende Bearbeitung vorgesehen ist, bei der primär eine hohe Haftfestigkeit der Hartstoffschicht gefordert ist, nur sekundär eine hohe Härte der Hartstoffschicht, und mindestens ein zweites Werkzeug vorgesehen ist, für eine spanende Bearbeitung, bei der primär eine hohe Härte der Hartstoffschicht gefordert ist, nur sekundär eine hohe Haftfestigkeit, wobei weiter die Hartstoffzusammensetzung am ersterwähnten, mindestens einen Werkzeug über dessen Wirkungskantenbereich eine im wesentlichen gleichbleibende Zusammensetzung aufweist, hingegen diese Beschichtung im Wirkungskantenbereich am mindestens einen zweiten Werkzeug im erwähnten Wirkungskantenbereich eine andere Zusammensetzung aufweist, verglichen mit übrigen Beschichtungsbereichen am genannten zweiten Werkzeug.

**11.** Werkzeugsatz nach Anspruch 10, dadurch gekennzeichnet, dass die Hartstoffschicht eine (Ti,Al)N-Schicht mindestens umfasst.

**12.** Werkzeugsatz nach einem der Ansprüche 10 oder 11, dadurch gekennzeichnet, dass das eine Werkzeug ein Bohrer, Schrupp-Fräser, Umfangsfräser, Wälzfräser oder ein Drehmesser ist, das zweite ein Stirnfräser oder Kugelkopffräser.

**13.** Werkzeugsatz nach einem der Ansprüche 10 bis 12, dadurch gekennzeichnet, dass das erste Werkzeug für den Einsatz bei verhältnismässig grossem Spannungsquerschnitt und bei kleinen Schnittgeschwindigkeiten vorgesehen ist, jedoch das zweite für den Einsatz bei verhältnismässig geringem Spannungsquerschnitt, aber relativ grosser Schnittgeschwindigkeit.

**14.** Werkzeugsatz nach einem der Ansprüche 10 bis 13, dadurch gekennzeichnet, dass das erste Werkzeug für die Bearbeitung von Werkstoffen mit einer Härte bis höchstens 45 Rockwell (HRC) vorgesehen ist und einer Zugfestigkeit bis höchstens 1500 N/mm$^2$, vorzugsweise für die Bearbeitung von Vergütungsstählen, hochlegierten Stählen, rostfreien Stählen sowie von Nichteisenmetallen.

**15.** Werkzeugsatz nach einem der Ansprüche 10 bis 14, dadurch gekennzeichnet, dass das erste Werkzeug mit einer Wirkungskante ausgebildet ist, welche im Werkzeugeinsatz mit unterschiedlichen Schnittgeschwindigkeiten gleichzeitig beansprucht wird.

**16.** Werkzeugsatz nach einem der Ansprüche 10 bis 15, dadurch gekennzeichnet, dass das zweite Werkzeug für die Bearbeitung von Werkstoffen mit einer Härte von mehr als 45 Rockwell (HRC) und mit einer Zugfestigkeit von mehr als 1500 N/mm$^2$ vorgesehen ist, insbesondere ein Hartzerspan-Werkzeug ist.

**17.** Werkzeugsatz nach einem der Ansprüche 10 bis 16, dadurch gekennzeichnet, dass das erste Werkzeug umfasst bzw. ist:

- eine Wendeschneidplatte für Drehmesser und zu bearbeitendes Material AISI 304SS bzw. DIN 1.4306 oder
- eine Wendeschneidplatte für Umfangfräser für zu bearbeitendes Material AISI 4140 bzw. DIN 1.7225 oder
- eine Wendeschneidplatten SEE 42TN für Fräser für zu bearbeitendes Material SKD 61 (HRC 45)
- einen Hartmetall-Schrupp-Schaftfräser für zu bearbeitendes Material DIN 1.2344 bei Trockenbearbeitung
- einen HSS-Bohrer für zu bearbeitendes Material AISI D3 bzw. DIN 1.2080 sowie für GG25 mit Emulsionsschmierung.

**18.** Werkzeugsatz nach einem der Ansprüche 10 bis 17, dadurch gekennzeichnet, dass das zweite Werkzeug ein Hartmetall-Schrupp-Schaftfräser für zu bearbeitendes Material DIN 1.2311 mit Emulsionsschmierung oder ein Hartmetall-Stirnfräser für die Bearbeitung von AISI D2 bzw. DIN 1.2379 oder

- ein Hartmetall-Kugelkopffräser für die Trockenbearbeitung von DIN 1.2343, 49.5 HRC ist.

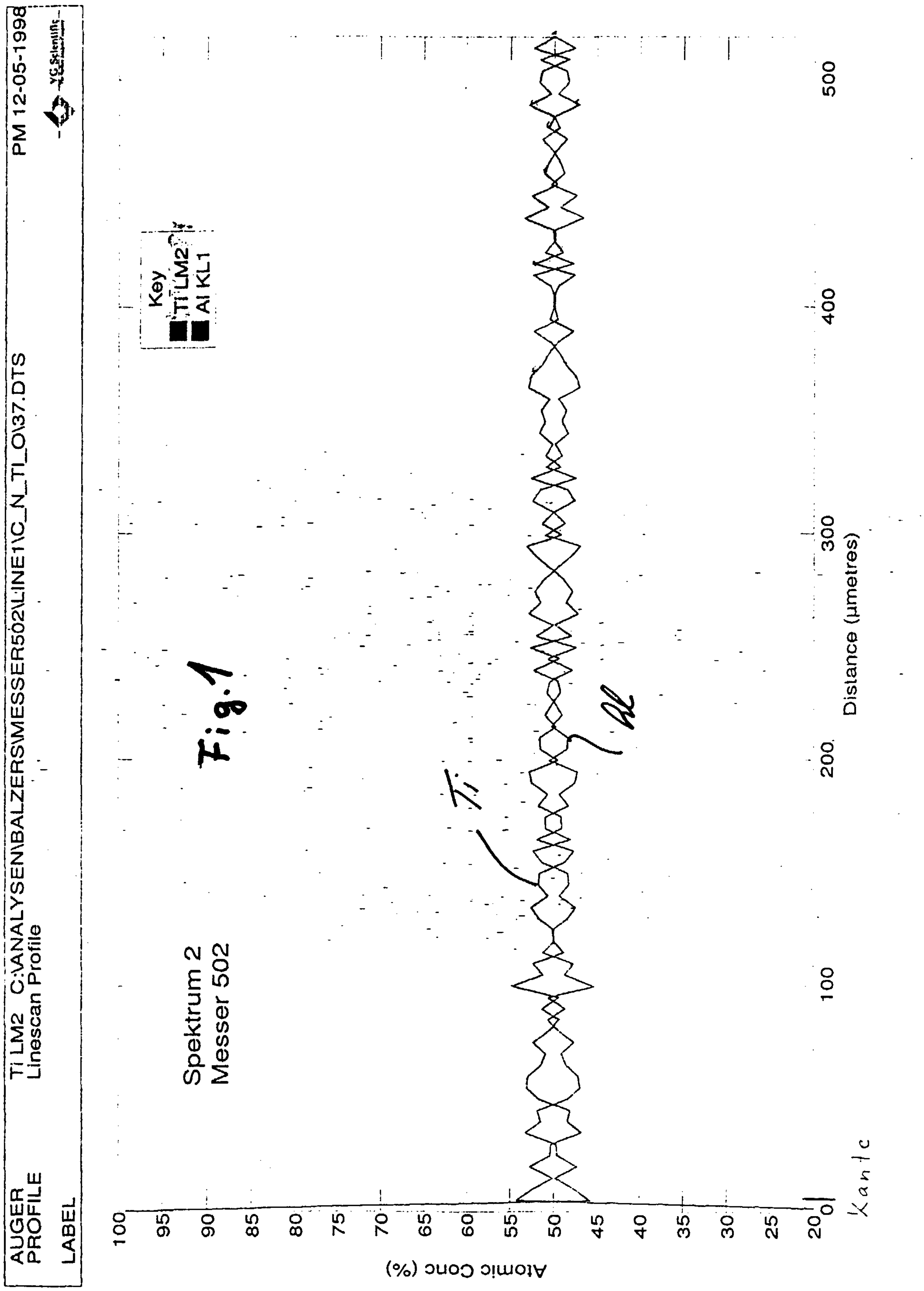
AUGER PROFILE
LABEL
Ti LM2 C:\ANALYSEN\BALZERS\MESSER\MESSER502\LINE1\C_N_TI_O\37.DTS
Linescan Profile
PM 12-05-1998
Key
Ti LM2
Al KL1
Spektrum 2
Messer 502
Ti
Al
Kante
Atomic Conc (%)
100 95 90 85 80 75 70 65 60 55 50 45 40 35 30 25 20
Distance (µmetres)
0 100 200 300 400 500

Fig. 1

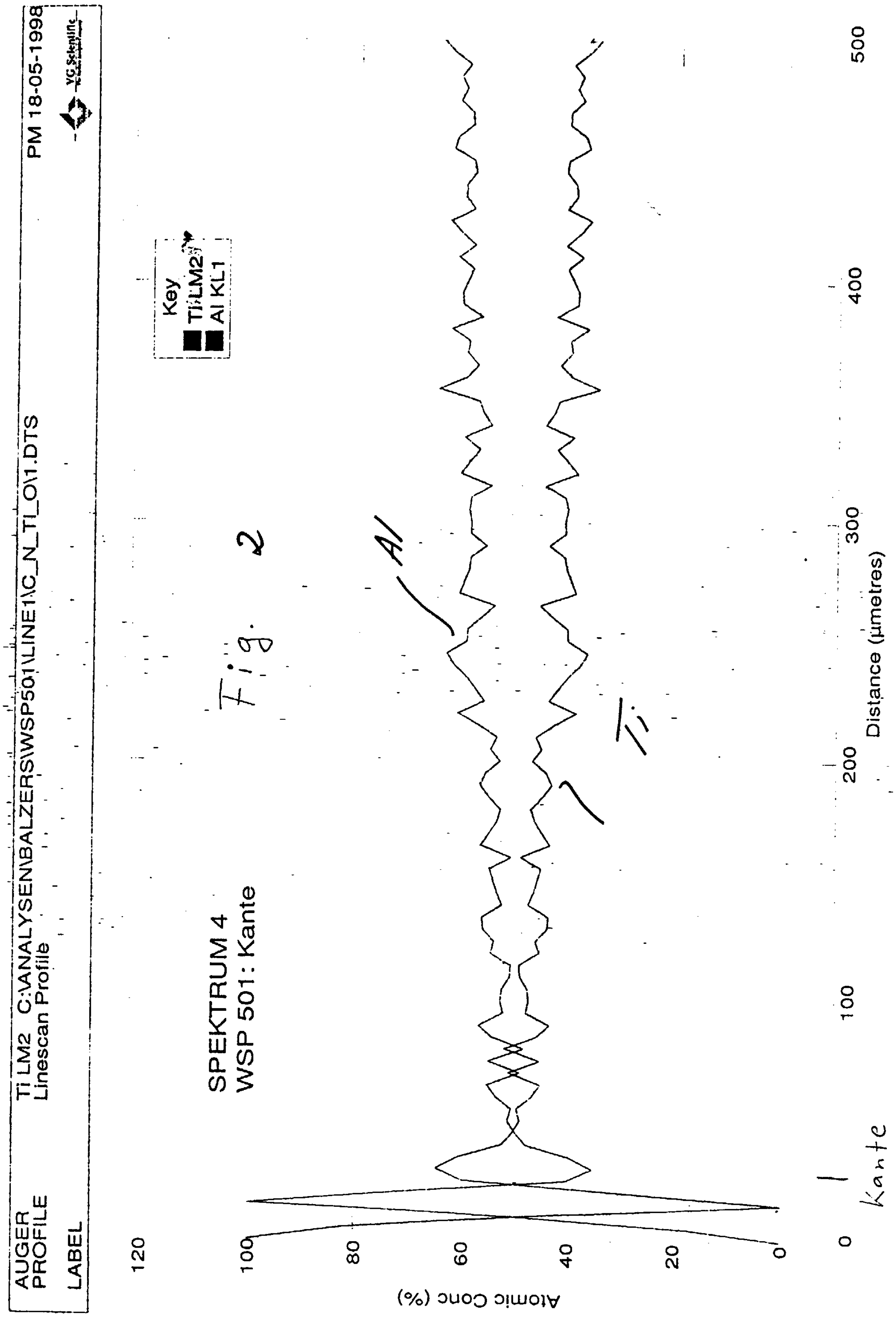
AUGER
PROFILE
LABEL
Ti LM2 C:\ANALYSEN\BALZERS\WSP501\LINE1\C_N_TI_O\1.DTS
Linescan Profile
PM 18-05-1998
VG Scientific
Key
Ti LM2
Al KL1
SPEKTRUM 4
WSP 501: Kante
Fig. 2
Al
Ti
Kante
Atomic Conc (%)
Distance (µmetres)
0
20
40
60
80
100
120
0
100
200
300
400
500

Figur 3

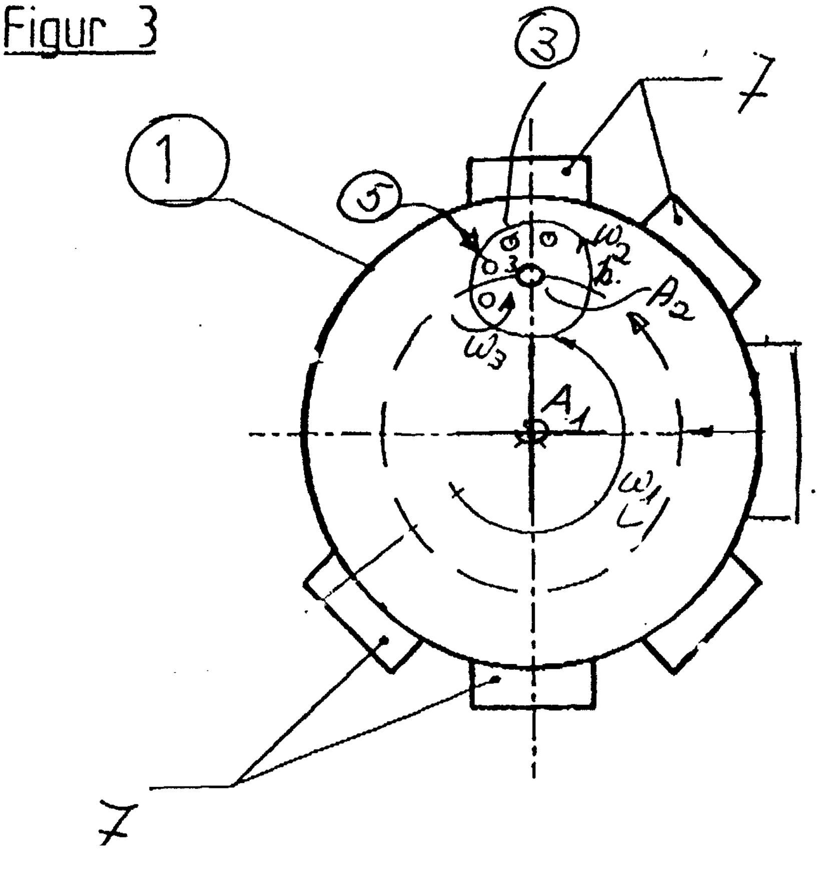

Europäisches Patentamt

# EUROPÄISCHER RECHERCHENBERICHT

Nummer der Anmeldung
EP 99 10 3093

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int.Cl.7) |
|---|---|---|---|
| X,D | US 5 272 014 A (LEYENDECKER TONI ET AL) 21. Dezember 1993 (1993-12-21)<br>* das ganze Dokument * | 1,2,4-8, 10,11, 13-16 | C23C30/00<br>C23C14/06<br>B23B27/00 |
| X | US 5 318 840 A (IKEDA TSUTOMU ET AL) 7. Juni 1994 (1994-06-07)<br>* Beispiel 1 * | 1,3 | |
| A | DE 195 17 120 A (KOBE STEEL LTD) 16. November 1995 (1995-11-16)<br>* Seite 4, Zeile 36; Anspruch 1; Abbildung 6 * | 9,12,17, 18 | |
| A | DE 195 26 387 A (RES INST FOR METAL SURFACE OF ;SUMITOMO METAL MINING CO (JP)) 29. Februar 1996 (1996-02-29)<br>* Beispiel 3 * | 1-18 | |

RECHERCHIERTE SACHGEBIETE (Int.Cl.7)
C23C
B23B

Der vorliegende Recherchenbericht wurde für alle Patentansprüche erstellt

| Recherchenort | Abschlußdatum der Recherche | Prüfer |
|---|---|---|
| DEN HAAG | 16. November 1999 | Ekhult, H |

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder nach dem Anmeldedatum veröffentlicht worden ist
D : in der Anmeldung angeführtes Dokument
L : aus anderen Gründen angeführtes Dokument

& : Mitglied der gleichen Patentfamilie,übereinstimmendes Dokument

EPO FORM 1503 03.82 (P04C03)

# ANHANG ZUM EUROPÄISCHEN RECHERCHENBERICHT ÜBER DIE EUROPÄISCHE PATENTANMELDUNG NR. EP 99 10 3093

In diesem Anhang sind die Mitglieder der Patentfamilien der im obengenannten europäischen Recherchenbericht angeführten Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

16-11-1999

| Im Recherchenbericht angeführtes Patentdokument | Datum der Veröffentlichung | Mitglied(er) der Patentfamilie | Datum der Veröffentlichung |
|---|---|---|---|
| US 5272014 A | 21-12-1993 | DE 3825399 A | 25-01-1990 |
| | | AT 96851 T | 15-11-1993 |
| | | DE 58906084 D | 09-12-1993 |
| | | EP 0352545 A | 31-01-1990 |
| | | ES 2045279 T | 16-01-1994 |
| | | JP 2080559 A | 20-03-1990 |
| | | JP 2941850 B | 30-08-1999 |
| US 5318840 A | 07-06-1994 | JP 2793696 B | 03-09-1998 |
| | | JP 4026756 A | 29-01-1992 |
| DE 19517120 A | 16-11-1995 | JP 2793772 B | 03-09-1998 |
| | | JP 7310173 A | 28-11-1995 |
| | | US 5656383 A | 12-08-1997 |
| DE 19526387 A | 29-02-1996 | JP 8035075 A | 06-02-1996 |
| | | JP 8296064 A | 12-11-1996 |
| | | FR 2722800 A | 26-01-1996 |

EPO FORM P0461

Für nähere Einzelheiten zu diesem Anhang : siehe Amtsblatt des Europäischen Patentamts, Nr.12/82